# EUROPEAN PATENT APPLICATION

(11) **EP 4 089 918 A1**
(43) Date of publication of application: **16.11.2022**
(21) Application number: 20896703.4
(22) Date of filing: 24.04.2020
(51) Int. Cl.: H03H 9/17, H03H 9/02, H03H 3/02, H03H 9/54

(54) **BULK ACOUSTIC WAVE RESONATOR AND MANUFACTURING METHOD, BULK ACOUSTIC WAVE RESONATOR UNIT, FILTER AND ELECTRONIC DEVICE**

(30) Priority: 06.12.2019 CN 201911241860
(71) Applicant: Tianjin University, Tianjin 300072 (CN); Rofs Microsystem (Tianjin) Co., Ltd, Tianjin 300462 (CN)
(72) Inventor: ZHANG, Menglun, Tianjin 300072 (CN); PANG, Wei, Tianjin 300072 (CN); YANG, Qingrui, Tianjin 300072 (CN)
(74) Representative: Meyer-Dulheuer MD Legal Patentanwälte PartG mbB
(86) International application number: PCT/CN2020/086564
(87) International publication number: WO 2021/109426

(57) **Abstract**

The present disclosure relates to a single crystal thin film bulk acoustic wave resonator, including: a substrate; an acoustic mirror; a bottom electrode connected with the bottom electrode pins; a top electrode connected with the top electrode pins; and a piezoelectric layer arranged between the bottom electrode and the top electrode, wherein: the piezoelectric layer is a single crystal thin film piezoelectric layer; the acoustic mirror, the bottom electrode, the top electrode and the single crystal thin film piezoelectric layer together form an effective area of the resonator in an overlapping region in the thickness direction of the resonator. The non-lead end of the top electrode and the non-lead end of the bottom electrode both can be spaced apart from the edge of the acoustic mirror in the projection in the thickness direction of the resonator. The present disclosure further relates to a method for manufacturing a single crystal thin film bulk acoustic wave resonator, a single crystal thin film bulk acoustic resonator unit having the above single crystal thin film resonator, and an electronic device.

## Description

### TECHNICAL FIELD

Embodiments of the present disclosure relates to the field of semiconductors, and in particular, to a bulk acoustic wave resonator, a filter having the resonator, a bulk acoustic wave resonator unit, and an electronic apparatus having the resonator or the filter.

### BACKGROUND

With development of 5G communication technologies, increasingly higher requirements have been posed for communication frequency bands. A traditional radio frequency filter cannot meet requirements for high-frequency communication due to limitation on the structure and performance. A film bulk acoustic resonator (FBAR) used as a new type of MEMS device is adapted to development of wireless communication systems, such that the FBAR technology becomes a research hotspot in the communication field. Compared with the traditional bulk wave acoustic resonator, the FBAR has advantages such as a small volume, light weight, low insertion loss, a wide bandwidth, and a high quality factor, and gradually occupies the market.

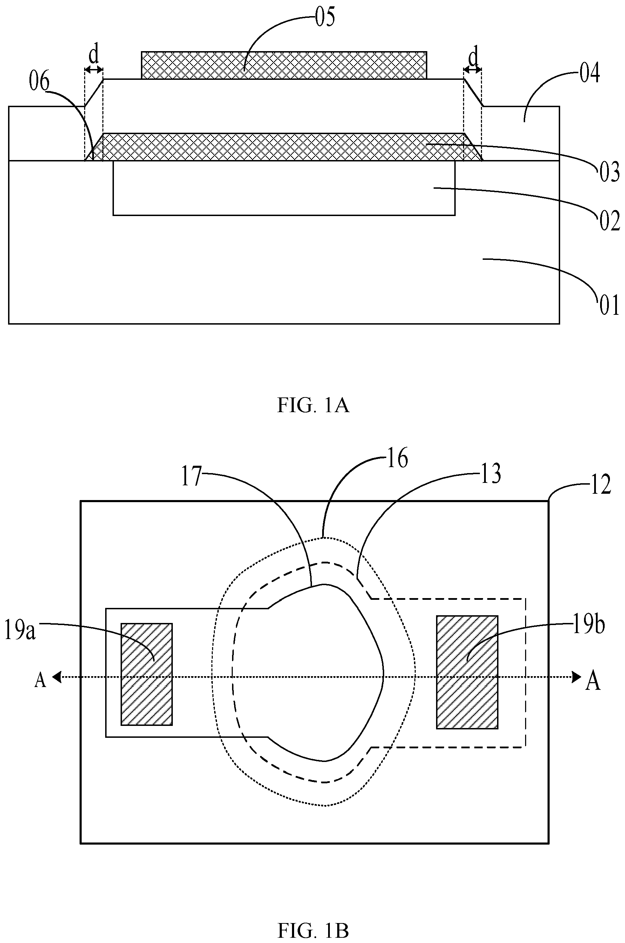

The film bulk acoustic resonator mainly includes a "sandwich" structure composed of electrode-piezoelectric film-electrode, i.e., the piezoelectric film is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output through a piezoelectric effect. The film bulk acoustic resonator mainly utilizes a longitudinal piezoelectric coefficient (d33) of the piezoelectric film to generate the piezoelectric effect, and thus mainly operates in a thickness extensional mode in a thickness direction. The conventional structure is shown in FIG. 1A, in which a substrate is indicated by 01, a cavity is indicated by 02, a bottom electrode is indicated by 03 and spans both sides of the cavity, a piezoelectric layer is indicated by 04, and a top electrode is indicated by 05.

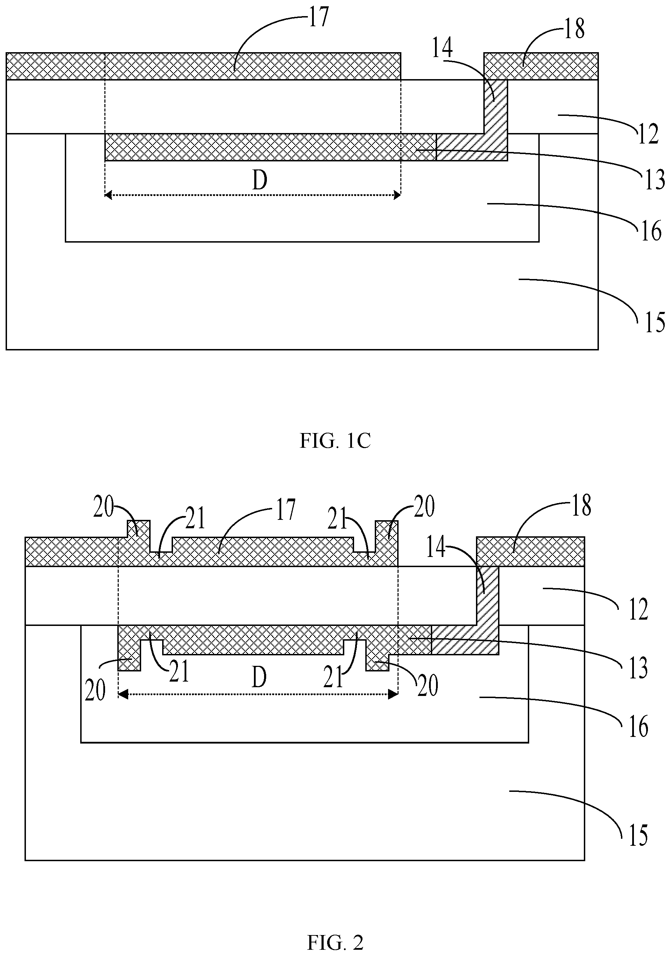

So far most of the piezoelectric films used in the traditional film bulk acoustic resonators are polycrystalline nitride films prepared by physical or chemical deposition techniques such as magnetron sputtering, which have poor piezoelectric property (mainly indicated by a low electromechanical coupling coefficient of the resonator), a high defect density (mainly indicated by a low quality factor of the resonator), and poor heat dissipation (mainly indicated by a low power capacity of the resonator). Moreover, etched inclined end faces 06 are formed at both ends of the bottom electrode of the resonator, as shown in FIG. 1. Since the etched inclined end face has a generally rough surface, defects in the piezoelectric layer deposited on the inclined end faces at the both ends of the bottom electrode may be further increased as shown in a region d in FIG. 1. These defects may lead to acoustic loss, thereby reducing a Q-factor of the resonator. Moreover, such the resonator cannot meet technical indexes such as lower insertion loss and larger bandwidth required in future mobile communication technologies.

### SUMMARY

In order to alleviate or solve at least one aspect of above problems in the related art, the present disclosure is provided.

According to an aspect of embodiments of the present disclosure, there is provided a bulk acoustic wave resonator that includes a substrate, an acoustic mirror, a bottom electrode connected to a bottom electrode pin, a top electrode connected to a top electrode pin, and a piezoelectric layer provided between the bottom electrode and the top electrode. The piezoelectric layer is a monocrystalline piezoelectric film layer. The acoustic mirror, the bottom electrode, the top electrode and the piezoelectric layer overlap with each other in a thickness direction of the resonator to form an overlapping region, and the overlapping region is an effective region of the resonator.

Optionally, a non-pin end of the top electrode and a non-pin end of the bottom electrode are both spaced apart from an edge of the acoustic mirror in a projection of the resonator in a thickness direction.

Optionally, the acoustic mirror is an acoustic mirror cavity arranged at an upper side of the substrate and is a blind hole cavity.

An embodiment of the present disclosure further relates to a bulk acoustic wave resonator unit, which includes the bulk acoustic wave resonator described above and a packaging substrate. The packaging substrate is provided with a circuit device that is electrically connected to the top electrode and the bottom electrode of the resonator, respectively.

The present disclosure also relates to a method of manufacturing a monocrystalline film bulk acoustic wave resonator. The monocrystalline film bulk acoustic wave resonator includes a substrate, an acoustic mirror, a bottom electrode connected to a bottom electrode pin, a top electrode connected to a top electrode pin, and a monocrystalline piezoelectric film layer provided between the bottom electrode and the top electrode. The method includes: forming the top electrode in such a manner that a non-pin end of the top electrode is spaced apart from an edge of the acoustic mirror in a projection of the resonator in a thickness direction; and forming the bottom electrode in such a manner that a non-pin end of the bottom electrode is spaced apart from the edge of the acoustic mirror in the projection of the resonator in the thickness direction.

An embodiment of the present disclosure also relates to a filter, which includes the above monocrystalline film bulk acoustic wave resonator, the above monocrystalline film bulk acoustic wave resonator unit, or the monocrystalline film bulk acoustic wave resonator manufactured by the method described above.

An embodiment of the present disclosure also relates to an electronic apparatus including the above filter, the above resonator, or the above resonator unit.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1A is a schematic sectional view of a conventional bulk acoustic wave resonator.
FIG. 1B is a schematic top view of a monocrystalline film bulk acoustic wave resonator according to an exemplary embodiment of the present disclosure.
FIG. 1C is a partial sectional schematic view along A-A in FIG. 1B according to an exemplary embodiment of the present disclosure.
FIG. 2 is a schematic sectional view of a monocrystalline film bulk acoustic wave resonator according to another exemplary embodiment of the present disclosure.
FIG. 3 is a schematic sectional view of a monocrystalline film bulk acoustic wave resonator according to an exemplary embodiment of the present disclosure.
FIG. 4 is a schematic sectional view of a monocrystalline film bulk acoustic wave resonator according to another exemplary embodiment of the present disclosure.
FIGS. 5A to 5D are process diagrams of a method of manufacturing a monocrystalline film bulk acoustic wave resonator according to an exemplary embodiment of the present disclosure.
FIGS. 6A to 6E are process diagrams of a method of manufacturing a monocrystalline film bulk acoustic wave resonator according to an exemplary embodiment of the present disclosure.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

FIG. 1B is a top view of a monocrystalline piezoelectric film bulk acoustic wave resonator according to an exemplary embodiment of the present disclosure. The reference sign 16 denotes an air gap or cavity of the monocrystalline film resonator. The reference sign 13 denotes a bottom electrode of the monocrystalline film resonator above the air gap. The reference sign 12 denotes a monocrystalline piezoelectric film layer of the resonator. The reference sign 17 denotes a top electrode of the monocrystalline film resonator above the monocrystalline piezoelectric layer. The reference sign 19a denotes an electrode connection structure on the top electrode. The reference sign 19b denotes an electrode connection structure on the bottom electrode. In FIG. 1B, it is different from the conventional structure shown in FIG. 1A in that the bottom electrode of the monocrystalline film resonator is located in the cavity in a vertical direction. In the conventional structure, the bottom electrode is located above the cavity in the vertical direction.

FIG. 1C is a schematic partial sectional view along A-A in FIG. 1B. The reference sign 15 denotes a substrate, the reference sign 16 denotes an air gap or cavity, the reference sign 13 denotes a bottom electrode, and the reference sign 12 denotes a monocrystalline piezoelectric film layer. A surface of the monocrystalline piezoelectric film layer may or may not be provided with a seed layer. The reference sign 14 denotes an electrode connection structure of the bottom electrode, the reference sign 17 denotes a top electrode, and the reference sign 18 denotes a bottom electrode pin layer located on an upper surface of the monocrystalline piezoelectric layer. A region where the bottom electrode, the monocrystalline piezoelectric film layer and the top electrode overlap with each other in a thickness direction of the resonator is an effective region of the monocrystalline film resonator, that is, a region indicated by D in FIG. 1C.

In addition, a cavity structure in the related art is generally a through hole passing through the substrate, but the deep etched through hole has disadvantages, such as poor control precision of a cavity shape and dimension, a complex process, complicated electrode connection, and a requirement for an additional packaging process to cover the through hole. In an embodiment of the present disclosure, the acoustic mirror cavity 16 is a blind hole, and in other words, the acoustic mirror cavity is sealed from below. In this way, a process flow is simplified, the cost is reduced, control precision of the shape and dimension is improved, the electrode connection is more reliable, and an additional through-hole packaging process is unnecessary.

In the embodiment shown in FIG. 1C, since parts of the top electrode and the bottom electrode in the effective region are both located within the cavity in the vertical direction. In other words, a non-pin end of the top electrode and a non-pin end of the bottom electrode are both spaced apart from an edge of the acoustic mirror in a projection of the monocrystalline film resonator in the thickness direction. This can avoid influence of secondary resonance and spurs generated by the overlapping portion of the top electrode and the bottom electrode in the vertical direction at an edge portion outside the effective region of the monocrystalline film resonator, to effectively improve a Q value of the monocrystalline film resonator.

A material of the piezoelectric layer is a monocrystalline piezoelectric film material, such that the defects of the traditional piezoelectric film material can be compensated, and properties of the resonator, such as an electromechanical coupling coefficient Kt², a quality factor Q value, and a power capacity, can be greatly improved. Moreover, properties of a filter formed by the monocrystalline piezoelectric film resonator of a monocrystalline piezoelectric film material, such as insertion loss and a suppression ratio of adjacent frequency bands, are also greatly improved.

FIG. 2 is a sectional view of a monocrystalline film bulk acoustic wave resonator according to another embodiment of the present disclosure. A structure of the monocrystalline film resonator shown in FIG. 2 is similar to that of the embodiment shown in FIG. 1C, except that a frame structure, i.e., a bulge structure 20 and a recess structure 21, is provided at edges of the top electrode 17 and the bottom electrode 13. The frame structure has a first acoustic impedance, and an effective region D of the monocrystalline film resonator has a second acoustic impedance. The transmission of sound waves is discontinuous at a boundary due to mismatch of the first acoustic impedance and the second acoustic impedance in the frame structure. Accordingly, a part of sound energy at the boundary is coupled and reflected into an effective excitation region, and is converted into a piston acoustic mode perpendicular to a surface of the piezoelectric layer, thereby improving the Q factor of the resonator.

In the embodiments shown in FIGS. 1C and 2, the acoustic mirror is a cavity. However, the present disclosure is not limited thereto, and other forms such as a Bragg reflection layer may be adopted.

When the acoustic mirror is a cavity as shown in FIGS. 1C and 2, in an embodiment of the present disclosure, the cavity is located between the substrate and a sandwich structure of the monocrystalline film resonator and the bottom electrode is located in the cavity.

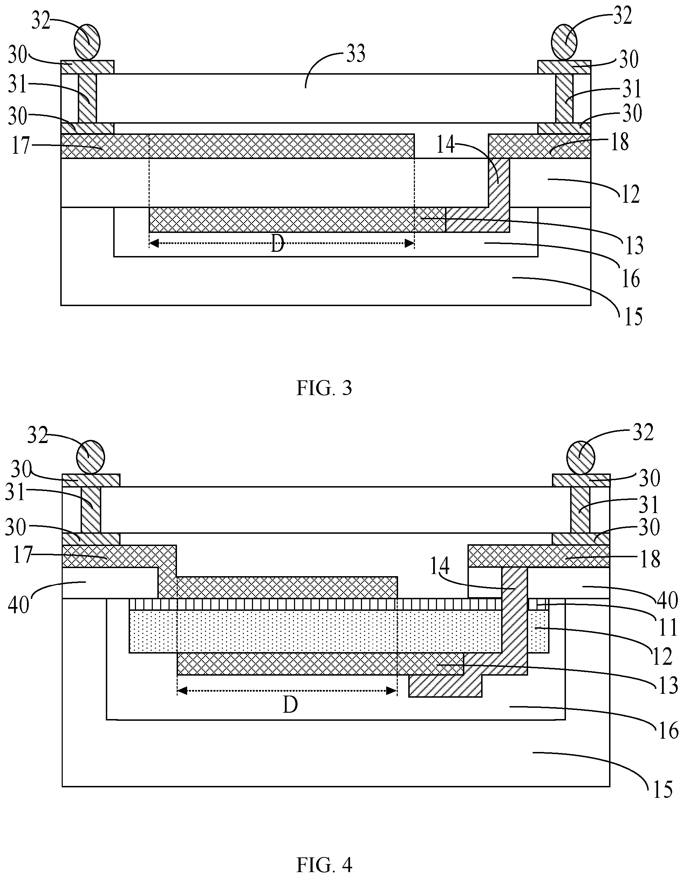

FIG. 3 is a schematic sectional view of a monocrystalline film bulk acoustic wave resonator unit according to an exemplary embodiment of the present disclosure, in which a packaging structure of the monocrystalline film bulk acoustic wave resonator is shown. The monocrystalline film resonator unit in FIG. 3 is different from the monocrystalline film resonator in FIG. 1C in that a packaging structure is provided above the monocrystalline film resonator and is formed by a bonding layer 30, connecting pillars 31, solder balls 32, and a packaging substrate 33. The monocrystalline film resonator is isolated from external environment by the packaging structure, and external environmental pollutants, such as external gas, steam, fluid and/or particles, can be prevented from entering an internal space or volume.

As shown in FIG. 3, the bottom electrode 13 is located in the cavity 15 in an embodiment.

FIG. 4 is a schematic sectional view of a monocrystalline film bulk acoustic wave resonator unit according to another exemplary embodiment of the present disclosure, in which a packaging structure of the monocrystalline film bulk acoustic wave resonator is shown. The monocrystalline film resonator unit in FIG. 4 is similar to the monocrystalline film resonator unit in FIG. 3, except that an insertion layer 40 is provided on a substrate 15 and is made of a material same as or different from that of the substrate 15. The insertion layer is provided to increase mechanical strength and stability of the monocrystalline film resonator, so that the monocrystalline film resonator can be applied in complex environment. Further, when the material of the insertion layer is the same as that of the substrate, the substrate is better able to be bonded to the insertion layer, to improve the sealing performance.

As shown in FIG. 4, the bottom electrode 13 and the piezoelectric layer 12 are both located in the cavity 16 in an embodiment.

As shown in FIGS. 3 and 4, in the monocrystalline film bulk acoustic wave resonator unit according to the present disclosure, the bottom electrode and the monocrystalline piezoelectric layer of the conventional structure are both located in the cavity in the vertical direction, but the bottom electrode and the piezoelectric layer are both located above the cavity in the vertical direction. In other words, the non-pin end of the top electrode and the non-pin end of the bottom electrode are both spaced apart from the edge of the acoustic mirror in the projection of the monocrystalline film resonator in the thickness direction. In this way, generation of spurs in the monocrystalline film resonator can be further avoided, the sound waves can be limited in the effective region of the monocrystalline film resonator, and the Q value of the monocrystalline film resonator can be improved.

As shown in FIGS. 1C, 2 and 3, in an embodiment of the present disclosure, the bottom electrode pin 14 passes through the monocrystalline piezoelectric layer 12 to be connected to the bottom electrode 13, and the bottom electrode pin 14 and the bottom electrode 13 are connected to each other in the same layer in the acoustic mirror cavity.

As shown in FIG. 4, in an embodiment of the present disclosure, the bottom electrode pin 14 passes through the monocrystalline piezoelectric layer 12 to be connected to the bottom electrode 13, but the bottom electrode pin 14 and the bottom electrode 13 are stacked and connected with each other in the acoustic mirror cavity.

As shown in FIGS. 1C, 2 and 3, in an embodiment of the present disclosure, a portion 18 of the bottom electrode pin 14 located at an upper side of the monocrystalline piezoelectric layer 12 is arranged in the same layer as the top electrode 17.

As shown in FIG. 4, in an embodiment of the present disclosure, the resonator further includes the insertion layer 40 between the monocrystalline piezoelectric layer and the bottom electrode pin located at the upper side of the monocrystalline piezoelectric layer and between the monocrystalline piezoelectric layer and the top electrode located at the upper side of the monocrystalline piezoelectric layer. Accordingly, as shown in FIG. 4, a portion of the bottom electrode pin located at the upper side of the monocrystalline piezoelectric layer is arranged in the same layer as the top electrode pin.

The monocrystalline piezoelectric film bulk acoustic wave resonator has a relatively high electromechanical coupling coefficient and a relatively high Q value, and a part of properties of the monocrystalline piezoelectric film bulk acoustic wave resonator is superior to those of the conventional bulk acoustic resonator formed by a piezoelectric film material. However, the monocrystalline piezoelectric film cannot be grown by the simple physical or chemical deposition, so that the resonator structure with the monocrystalline piezoelectric film and the manufacturing method thereof are completely different from the resonator with the polycrystalline piezoelectric film. This means that the resonator structure and processing method are required to be innovated. According to the present disclosure, the traditional FBAR structure and its manufacturing method are changed in a way that the piezoelectric layer of the resonator is made of a monocrystalline piezoelectric material, which can greatly improve the electromechanical coupling coefficient of the resonator and reduce the insertion loss of the filter.

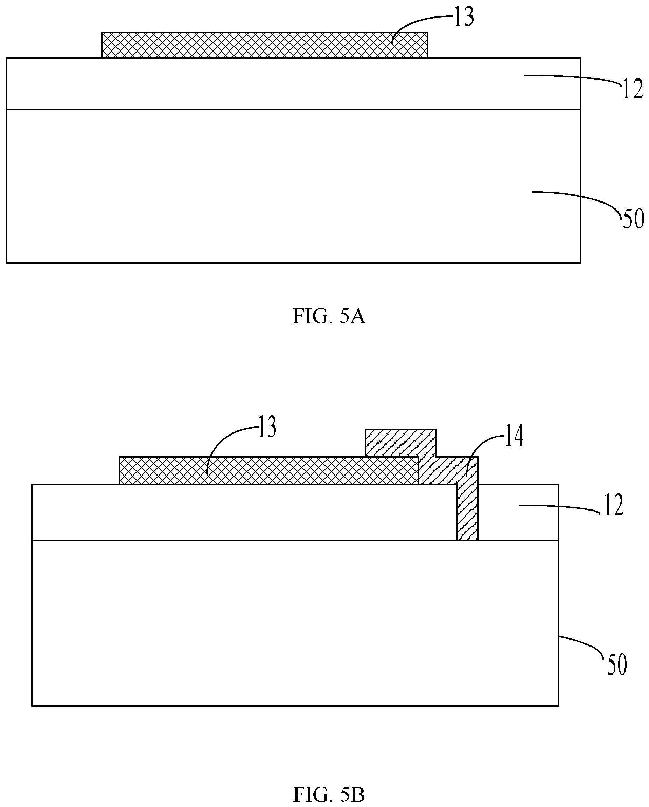

FIGS. 5A to 5D are process diagrams of a method of manufacturing a monocrystalline film bulk acoustic wave resonator according to an exemplary embodiment of the present disclosure. Referring to FIGS. 5A to 5D, a processing flow of the monocrystalline piezoelectric film bulk acoustic wave resonator is illustrated below.

Firstly, a monocrystalline piezoelectric layer and a bottom electrode are formed, as shown in FIG. 5A. A monocrystalline piezoelectric layer 12 is firstly epitaxially grown on a substrate 50. The monocrystalline piezoelectric layer 12 may be grown by an epitaxial growth method, such as MOCVD (Metal Organic Chemical Vapor Deposition), MBE (Molecular Beam Epitaxy), CBE (Chemical Molecular Beam Epitaxy), and LPE (Liquid Phase Epitaxy). In an embodiment, a monocrystalline seed layer is formed. Then, a bottom electrode layer 13 is deposited on the monocrystalline piezoelectric layer by a film deposition process, such as CVD (Chemical Vapor Deposition), PVD (Physical Vapor Deposition), PECVD (Plasma Enhanced Chemical Vapor Deposition), evaporation, and sputtering.

After that, a bottom electrode connection layer is formed, as shown in FIG. 5B. A through hole is formed in the monocrystalline piezoelectric layer 12 by photolithography and etching, and an electrode connection layer 14 is formed to be connected with the bottom electrode 13 by a thin film deposition process.

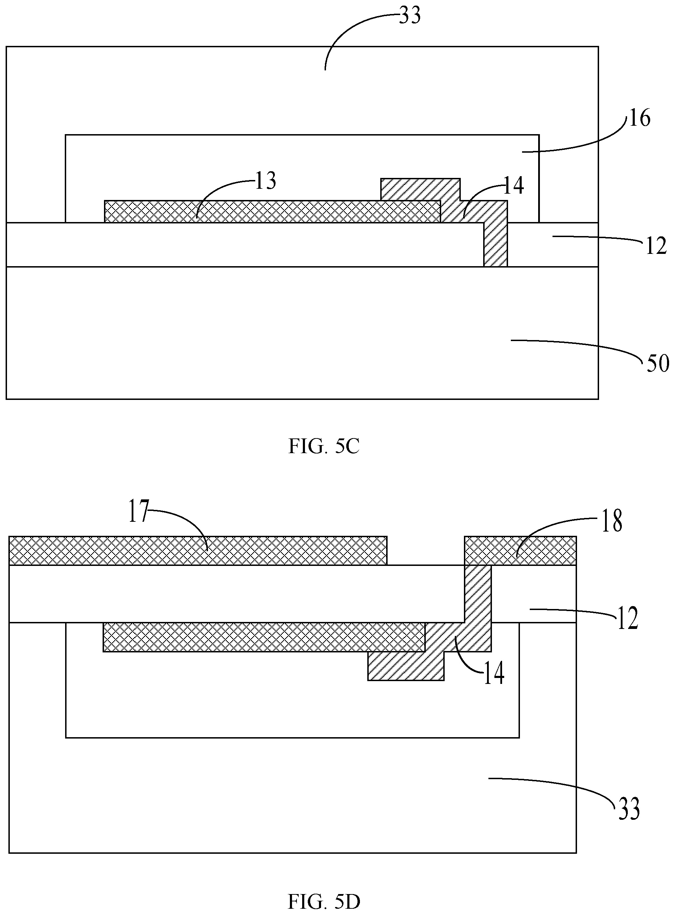

Thereafter, bonding is performed as shown in FIG. 5C. A substrate 33 is attached to the monocrystalline piezoelectric layer 12 by bonding, and an auxiliary layer may be provided between the substrate 33 and the monocrystalline piezoelectric layer 12 to improve the bonding strength or stick the substrate 33 and the monocrystalline piezoelectric layer 12 with each other. An air gap 13 is formed between the substrate and the bottom electrode 13. The air gap 13 is functions to confine the sound waves in the resonator. Since the acoustic impedance of air is nearly zero and does not match the acoustic impedance in the resonator, the sound waves can be reflected back into the effective region of the resonator and the Q factor of the resonator can be improved.

Finally, as shown in FIG. 5D, the substrate 50 is removed to form a top electrode 17 and a pin layer 18 of the bottom electrode. The structure in FIG. 5C is then turned upside down to make the substrate facing upwards. The substrate 50 is thinned by mechanical grinding, and the remaining part of the substrate is then completely removed by etching. After that, a thin film is deposited by photolithography and etching processes to form the top electrode 17 and the pin layer 18 of the bottom electrode. The pin layer is electrically connected to the bottom electrode connection layer 14.

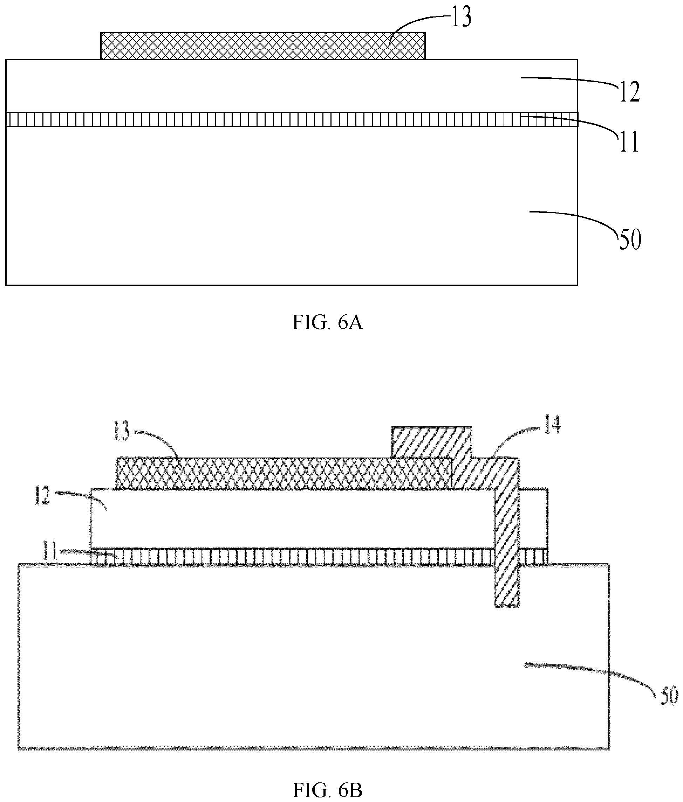

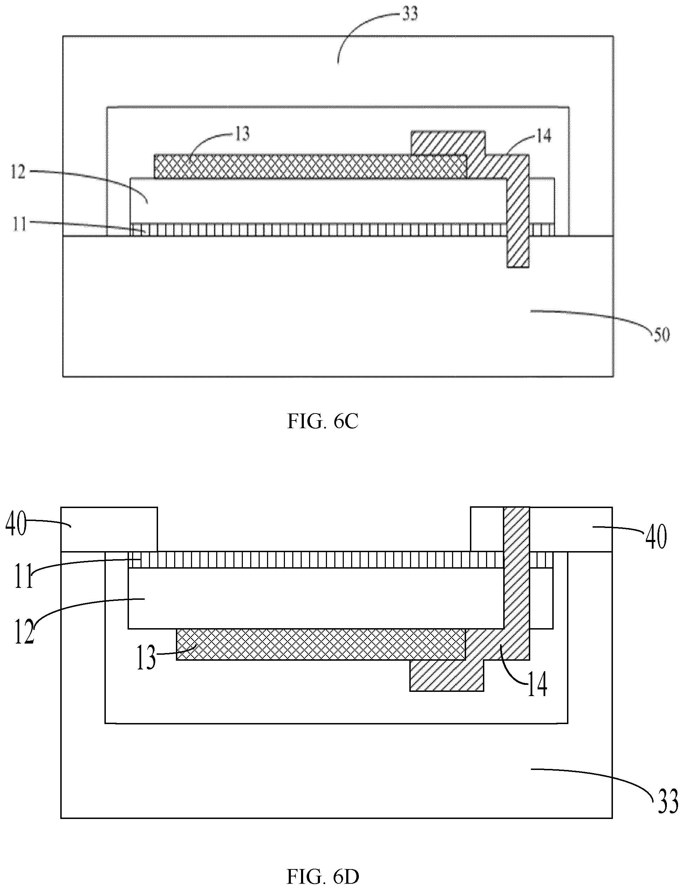

FIGS. 6A to 6E are process diagrams of a method of manufacturing a monocrystalline film bulk acoustic wave resonator according to another exemplary embodiment of the present disclosure. Referring to FIGS. 6A to 6E, a processing flow of the monocrystalline piezoelectric film bulk acoustic wave resonator is illustrated below.

Firstly, a monocrystalline piezoelectric layer and a bottom electrode are formed, as shown in FIG. 6A. A monocrystalline seed layer 11 is firstly grown epitaxially on a substrate 50. The monocrystalline seed layer may be grown by an epitaxial growth method, such as MOCVD (Metal Organic Chemical Vapor Deposition), MBE (Molecular Beam Epitaxy), CBE (Chemical Molecular Beam Epitaxy), and LPE (Liquid Phase Epitaxy). A monocrystalline seed layer is provided to promote growth of the monocrystalline piezoelectric layer on the substrate. The material of the seed layer may be different from that of the piezoelectric layer 11. When the material of the seed layer is different from that of the piezoelectric layer, the seed layer can be used as a barrier layer of the etching process to prevent the piezoelectric layer from being etched in a subsequent process. Further, the monocrystalline seed layer can facilitate the piezoelectric layer to have a good crystal orientation during the epitaxial growth process. A monocrystalline piezoelectric layer 12 is then epitaxially grown. After that, a bottom electrode layer 13 is deposited on the monocrystalline piezoelectric layer by a film deposition process, such as CVD (Chemical Vapor Deposition), PVD (Physical Vapor Deposition), PECVD (Plasma Enhanced Chemical Vapor Deposition), evaporation, and sputtering.

After that, a bottom electrode connection layer is formed, as shown in FIG. 6B. Redundant parts of the monocrystalline piezoelectric material and the seed layer are etched away by photolithography and etching processes, and two sides of the substrate 50 are exposed. It is necessary to form a through hole for forming a bottom electrode connection layer 14 in the monocrystalline seed layer and the substrate. Referring to FIG. 6B, the through hole passes through the monocrystalline seed layer 11 and extends into the substrate 50. The electrode connection layer 14 is then formed to be connected with the bottom electrode 13 through a film deposition process.

Thereafter, bonding is performed, as shown in FIG. 6C. A substrate 33 is attached to the substrate 33. A direct bonding technology, such as Si-Si bonding, may be adopted between the substrates 33 and 50, or an auxiliary layer may be provided to improve the bonding strength or stick the substrates 33 and 50 with each other. An air gap 13 is formed between the substrate 33 and the bottom electrode 13. The air gap 13 functions to confine the sound waves in the resonator. Since the acoustic impedance of air is nearly zero and does not match the acoustic impedance in the resonator, the sound waves can be reflected back into the effective region of the resonator and the Q factor of the resonator can be improved.

Thereafter, the substrate 50 is then removed, and an insertion layer 40 is formed through which the through hole passes as shown in the figure. The structure in FIG. 6C is then turned upside down such that the substrate faces upwards. The substrate 50 is thinned by mechanical grinding, and a part of the substrate is then completely removed by etching to form the insertion layer structure 40. The insertion layer can increase the mechanical strength and stability of the monocrystalline film resonator, which can make it is used in complex environment. Further, when the material of the insertion layer is the same as that of the substrate, the substrate can be better bonded to the insertion layer, and the sealing performance can be improved. Meanwhile, damage to the monocrystalline piezoelectric layer 12 at the bottom can be prevented due to the seed layer 11 during the etching process of removing the substrate.

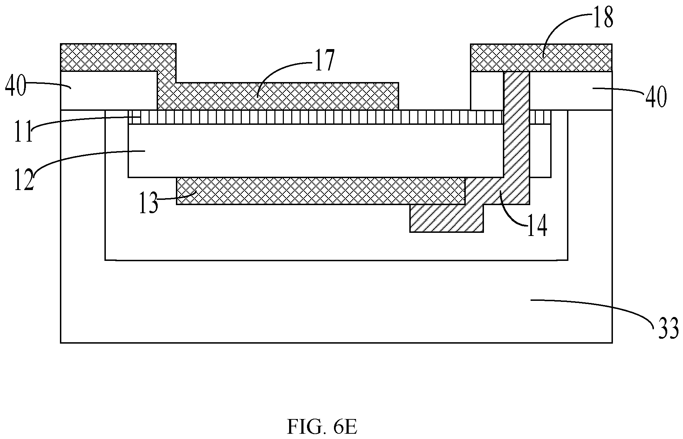

Finally, the top electrode 17 and the pin layer 18 of the bottom electrode are formed. An electrode film is firstly deposited, and the top electrode 17 and the pin layer 18 of the bottom electrode are then formed by photolithography and etching processes. Referring to FIG. 6E, the pin layer 18 is electrically connected to the through hole or the electrode connection layer 14 of the bottom electrode.

In the present disclosure, the material of the monocrystalline piezoelectric layer may be monocrystalline aluminum nitride, monocrystalline lithium niobate, monocrystalline lead zirconate titanate, monocrystalline potassium niobate, monocrystalline quartz film, monocrystalline lithium tantalate or the like.

The material of the top electrode may be following metals or alloys thereof, such as gold, tungsten, molybdenum, platinum, ruthenium, iridium, germanium, copper, titanium, titanium tungsten, aluminum, chromium, and arsenic doped gold. Similarly, the material of the bottom electrode is following metals or alloys thereof, such as gold, tungsten, molybdenum, platinum, ruthenium, iridium, germanium, copper, titanium, titanium tungsten, aluminum, chromium, and arsenic doped gold. The materials of the top electrode and the bottom electrode are generally the same, but they may be different.

The material of the substrate includes Si, quartz, monocrystalline AlN, LiNbO₃, TaNbO₃, SiC, GaN, GaAs, PZT, sapphire, diamond or the like.

A numerical range mentioned in the present disclosure encompass not only end values, but also a median value or other values between the end values, all of which fall within the scope of the present disclosure.

As can be understood by those skilled in the art, the bulk acoustic wave resonator according to the present disclosure can be used to form a filter or other semiconductor devices.

In view of the above, the present disclosure provides following technical solutions.
1. A bulk acoustic wave resonator includes:
   a substrate;
   an acoustic mirror;
   a bottom electrode connected to a bottom electrode pin;
   a top electrode connected to a top electrode pin; and
   a piezoelectric layer provided between the bottom electrode and the top electrode,
   wherein the piezoelectric layer is a monocrystalline piezoelectric film layer; and
   wherein the acoustic mirror, the bottom electrode, the top electrode and the piezoelectric layer overlap with each other in a thickness direction of the resonator to form an overlapping region, and the overlapping region is an effective region of the resonator.
2. The resonator according to 1, wherein
   a non-pin end of the top electrode and a non-pin end of the bottom electrode are both spaced apart from an edge of the acoustic mirror in a projection of the resonator in the thickness direction.
3. The resonator according to 1 or 2, wherein
   the acoustic mirror is an acoustic mirror cavity arranged at an upper side of the substrate and is a blind hole.
4. The resonator according to 3, wherein
   the bottom electrode is located in the acoustic mirror cavity, or the bottom electrode and the piezoelectric layer are both located in the acoustic mirror cavity.
5. The resonator according to 4, wherein
   the bottom electrode pin passes through a piezoelectric layer through hole of the piezoelectric layer to be connected to the bottom electrode, and a portion of the bottom electrode pin located at an upper side of the piezoelectric layer is arranged in a same layer as the top electrode.
6. The resonator according to 4, wherein
   the bottom electrode pin passes through a piezoelectric layer through hole of the piezoelectric layer to be connected to the bottom electrode;
   the resonator further includes an insertion layer, and the insertion layer is provided between the piezoelectric layer and the bottom electrode pin located at an upper side of the piezoelectric layer and between the piezoelectric layer and the top electrode located at the upper side of the piezoelectric layer; and
   a portion of the bottom electrode pin located at the upper side of the piezoelectric layer is arranged in a same layer as the top electrode pin.
7. The resonator according to 5 or 6, wherein
   the bottom electrode pin is connected with the bottom electrode in the same layer within the acoustic mirror cavity; or
   the bottom electrode pin and the bottom electrode are connected to and stacked with each other in the acoustic mirror cavity.
8. The resonator according to 5 or 6, wherein
   the piezoelectric layer through hole is located at an inner side of an edge of the acoustic mirror cavity.
9. The resonator according to 1 or 2, wherein
   an acoustic impedance mismatch structure is provided at a lower side of an edge of the bottom electrode.
10. The resonator according to 9, wherein
   the acoustic impedance mismatch structure includes a bulge structure and a recess structure.
11. The resonator according to 1 or 2, wherein
   a material of the monocrystalline piezoelectric layer is monocrystalline aluminum nitride, monocrystalline lithium niobate, monocrystalline lead zirconate titanate, monocrystalline potassium niobate, monocrystalline quartz film, or monocrystalline lithium tantalate.
12. A bulk acoustic wave resonator unit includes:
   the resonator according to any one of 1 to 11; and
   a packaging substrate provided with a circuit device, the circuit device being electrically connected to the top electrode and the bottom electrode of the resonator, respectively.
13. The resonator unit according to 12, wherein
   the bottom electrode pin passes through the piezoelectric layer to be connected to the bottom electrode, and a portion of the bottom electrode pin located at an upper side of the piezoelectric layer is arranged in a same layer as the top electrode pin; and
   the circuit device includes a bonding layer provided at a lower side of the packaging substrate and a conductive through hole passing through the packaging substrate, and the bonding layer is electrically connected with the conductive through hole and a corresponding one of the bottom electrode pin and the top electrode pin.
14. A method of manufacturing a monocrystalline film bulk acoustic wave resonator is provided, in which the monocrystalline film bulk acoustic wave resonator includes a substrate, an acoustic mirror, a bottom electrode connected to a bottom electrode pin, a top electrode connected to a top electrode pin, and a monocrystalline piezoelectric film layer provided between the bottom electrode and the top electrode, the method includes:
   forming the top electrode in such a manner that a non-pin end of the top electrode is spaced apart from an edge of the acoustic mirror in a projection of the monocrystalline film resonator in a thickness direction; and
   forming the bottom electrode in such a manner that a non-pin end of the bottom electrode is spaced apart from the edge of the acoustic mirror in the projection of the monocrystalline film resonator in the thickness direction.
15. The method according to 14 further includes:
   sequentially forming the monocrystalline piezoelectric film layer and the bottom electrode on the substrate;
   forming a through hole on the monocrystalline piezoelectric film layer, and forming an electrode connection layer of the bottom electrode at one side of the monocrystalline piezoelectric film layer, in such a manner that the electrode connection layer of the bottom electrode is electrically connected to the bottom electrode and includes a portion located in the through hole;
   providing the substrate on the monocrystalline piezoelectric film layer and forming the acoustic mirror in the substrate, the substrate being formed to be hermetically bonded to the monocrystalline piezoelectric film layer;
   removing the substrate located at another side of the monocrystalline piezoelectric film layer; and
   forming the top electrode and a pin layer electrically connected to a part of the electrode connection layer of the bottom electrode in the through hole at the another side of the monocrystalline piezoelectric film layer.
16. The method according to 14 further includes:
   sequentially forming the monocrystalline piezoelectric film layer and the bottom electrode on the substrate;
   forming an electrode connection layer of the bottom electrode at one side of the monocrystalline piezoelectric film layer, in such a manner that the electrode connection layer of the bottom electrode is electrically connected to the bottom electrode;
   providing the substrate on the monocrystalline piezoelectric film layer and forming the acoustic mirror in the substrate, the substrate being formed to be hermetically bonded to the monocrystalline piezoelectric film layer;
   removing the substrate located at another side of the monocrystalline piezoelectric film layer; and
   forming the top electrode and a pin layer electrically connected to the electrode connection layer of the bottom electrode at the another side of the monocrystalline piezoelectric film layer.
17. The method according to 15, wherein before the sequentially forming the monocrystalline piezoelectric film layer and the bottom electrode on the substrate, the method further includes forming a monocrystalline seed layer on the substrate;
   in the forming the through hole on the monocrystalline piezoelectric film layer, the through hole passes through the monocrystalline seed layer; and
   in the forming the top electrode at the another side of the monocrystalline piezoelectric film layer, the top electrode is formed on the monocrystalline seed layer located at the another side of the monocrystalline piezoelectric film layer.
18. The method according to 15, wherein before the sequentially forming the monocrystalline piezoelectric film layer and the bottom electrode on the substrate, the method further includes forming a monocrystalline seed layer on the substrate; and
   in the forming the top electrode at the another side of the monocrystalline piezoelectric film layer, the top electrode is formed on the monocrystalline seed layer located at the another side of the monocrystalline piezoelectric film layer.
19. The method according to 15 or 16, wherein
   in the forming the through hole in the monocrystalline piezoelectric film layer, the through hole passes through the monocrystalline seed layer and extends into the substrate;
   in the removing the substrate located at the another side of the monocrystalline piezoelectric film layer, the substrate is etched, an insertion layer structure is formed, and the insertion layer structure extends to an inner side of the edge of the acoustic mirror in a lateral direction; and
   in the forming the top electrode and the pin layer electrically connected to the electrode connection layer of the bottom electrode at the another side of the monocrystalline piezoelectric film layer, the top electrode covers the insertion layer structure, the pin layer of the bottom electrode covers the insertion layer structure, and the pin layer of the bottom electrode is electrically connected to the through hole.
20. The method according to any one of 14 to 19, wherein
   the acoustic mirror is an acoustic mirror cavity, the acoustic mirror cavity is formed between the substrate and the monocrystalline piezoelectric film layer, and the acoustic mirror cavity is a blind hole cavity.
21. A filter includes the bulk acoustic wave resonator according to any one of 1 to 11, the bulk acoustic wave resonator unit according to 12 or 13, or a monocrystalline film bulk acoustic wave resonator manufactured by the method according to any one of 14 to 20.
22. An electronic apparatus includes the filter according to 21, the bulk acoustic wave resonator according to any one of 1 to 11, the bulk acoustic wave resonator unit according to 12 or 13, or a monocrystalline film bulk acoustic wave resonator manufactured by the method according to any one of 14 to 20.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
an acoustic mirror;
a bottom electrode connected to a bottom electrode pin;
a top electrode connected to a top electrode pin; and
a piezoelectric layer provided between the bottom electrode and the top electrode,
wherein the piezoelectric layer is a monocrystalline piezoelectric film layer; and
wherein the acoustic mirror, the bottom electrode, the top electrode and the monocrystalline piezoelectric film layer overlap with each other in a thickness direction of the resonator to form an overlapping region, and the overlapping region is an effective region of the resonator.

2. The resonator according to claim 1, wherein a non-pin end of the top electrode and a non-pin end of the bottom electrode are both spaced apart from an edge of the acoustic mirror in a projection of the resonator in the thickness direction.

3. The resonator according to claim 1 or 2, wherein the acoustic mirror is an acoustic mirror cavity arranged at an upper side of the substrate and is a blind hole cavity.

4. The resonator according to claim 3, wherein the bottom electrode is located in the acoustic mirror cavity, or the bottom electrode and the piezoelectric layer are both located in the acoustic mirror cavity.

5. The resonator according to claim 4, wherein the bottom electrode pin passes through a piezoelectric layer through hole of the piezoelectric layer to be connected to the bottom electrode, and a portion of the bottom electrode pin located at an upper side of the piezoelectric layer is arranged in a same layer as the top electrode.

6. The resonator according to claim 4, wherein the bottom electrode pin passes through a piezoelectric layer through hole of the piezoelectric layer to be connected to the bottom electrode;
the resonator further comprises an insertion layer, and the insertion layer is provided between the piezoelectric layer and the bottom electrode pin located at an upper side of the piezoelectric layer and between the piezoelectric layer and the top electrode located at the upper side of the piezoelectric layer; and
a portion of the bottom electrode pin located at the upper side of the piezoelectric layer is arranged in a same layer as the top electrode pin.

7. The resonator according to claim 5 or 6, wherein the bottom electrode pin is connected with the bottom electrode in the same layer within the acoustic mirror cavity; or
the bottom electrode pin and the bottom electrode are connected to and stacked with each other within the acoustic mirror cavity.

8. The resonator according to claim 5 or 6, wherein the piezoelectric layer through hole is located at an inner side of an edge of the acoustic mirror cavity.

9. The resonator according to claim 1 or 2, further comprising:
an acoustic impedance mismatch structure provided at a lower side of an edge of the bottom electrode.

10. The resonator according to claim 9, wherein the acoustic impedance mismatch structure comprises a bulge structure and a recess structure.

11. The resonator according to claim 1 or 2, wherein a material of the monocrystalline piezoelectric layer is monocrystalline aluminum nitride, monocrystalline lithium niobate, monocrystalline lead zirconate titanate, monocrystalline potassium niobate, monocrystalline quartz film, or monocrystalline lithium tantalate.

12. A bulk acoustic wave resonator unit, comprising:
the resonator according to any one of claims 1 to 11; and
a packaging substrate provided with a circuit device, the circuit device being electrically connected to the top electrode and the bottom electrode of the resonator, respectively.

13. The resonator unit according to claim 12, wherein the bottom electrode pin passes through the piezoelectric layer to be connected to the bottom electrode, and a portion of the bottom electrode pin located at an upper side of the piezoelectric layer is arranged in a same layer as the top electrode pin; and
the circuit device comprises a bonding layer provided at a lower side of the packaging substrate and a conductive through hole passing through the packaging substrate, and the bonding layer is electrically connected with the conductive through hole and a corresponding one of the bottom electrode pin and the top electrode pin.

14. A method of manufacturing a monocrystalline film bulk acoustic wave resonator, wherein the monocrystalline film bulk acoustic wave resonator comprises a substrate, an acoustic mirror, a bottom electrode connected to a bottom electrode pin, a top electrode connected to a top electrode pin, and a monocrystalline piezoelectric film layer provided between the bottom electrode and the top electrode, the method comprises:
forming the top electrode in such a manner that a non-pin end of the top electrode is spaced apart from an edge of the acoustic mirror in a projection of the monocrystalline film resonator in a thickness direction; and
forming the bottom electrode in such a manner that a non-pin end of the bottom electrode is spaced apart from the edge of the acoustic mirror in the projection of the monocrystalline film resonator in the thickness direction.

15. The method according to claim 14, further comprising:
sequentially forming the monocrystalline piezoelectric film layer and the bottom electrode on the substrate;
forming a through hole on the monocrystalline piezoelectric film layer, and forming an bottom electrode connection layer at one side of the monocrystalline piezoelectric film layer, in such a manner that the bottom electrode connection layer is electrically connected to the bottom electrode and comprises a portion located in the through hole;
providing the substrate on the monocrystalline piezoelectric film layer and forming the acoustic mirror in the substrate, the substrate being formed to be hermetically bonded to the monocrystalline piezoelectric film layer;
removing the substrate located at another side of the monocrystalline piezoelectric film layer; and
forming, at the another side of the monocrystalline piezoelectric film layer, the top electrode and a pin layer electrically connected to a part of the bottom electrode connection layer in the through hole.

16. The method according to claim 14, further comprising:
sequentially forming the monocrystalline piezoelectric film layer and the bottom electrode on the substrate;
forming a bottom electrode connection layer at one side of the monocrystalline piezoelectric film layer, in such a manner that the bottom electrode connection layer is electrically connected to the bottom electrode;
providing the substrate on the monocrystalline piezoelectric film layer and forming the acoustic mirror in the substrate, the substrate being formed to be hermetically bonded to the monocrystalline piezoelectric film layer;
removing the substrate located at another side of the monocrystalline piezoelectric film layer; and
forming the top electrode and a pin layer electrically connected to the bottom electrode connection layer at the another side of the monocrystalline piezoelectric film layer.

17. The method according to claim 15, wherein before the sequentially forming the monocrystalline piezoelectric film layer and the bottom electrode on the substrate, the method further comprises forming a monocrystalline seed layer on the substrate;
in the forming the through hole on the monocrystalline piezoelectric film layer, the through hole passes through the monocrystalline seed layer; and
in the forming the top electrode at the another side of the monocrystalline piezoelectric film layer, the top electrode is formed on the monocrystalline seed layer located at the another side of the monocrystalline piezoelectric film layer.

18. The method according to claim 15, wherein before the sequentially forming the monocrystalline piezoelectric film layer and the bottom electrode on the substrate, the method further comprises forming a monocrystalline seed layer on the substrate; and
in the forming the top electrode at the another side of the monocrystalline piezoelectric film layer, the top electrode is formed on the monocrystalline seed layer located at the another side of the monocrystalline piezoelectric film layer.

19. The method according to claim 15 or 16, wherein in the forming the through hole in the monocrystalline piezoelectric film layer, the through hole passes through the monocrystalline seed layer and extends into the substrate;
in the removing the substrate located at the another side of the monocrystalline piezoelectric film layer, the substrate is etched, an insertion layer structure is formed, and the insertion layer structure extends to an inner side of the edge of the acoustic mirror in a lateral direction; and
in the forming the top electrode and the pin layer electrically connected to the electrode connection layer of the bottom electrode at the another side of the monocrystalline piezoelectric film layer, the top electrode covers the insertion layer structure, the pin layer of the bottom electrode covers the insertion layer structure, and the pin layer of the bottom electrode is electrically connected to the through hole.

20. The method according to any one of claims 14 to 19, wherein the acoustic mirror is an acoustic mirror cavity, the acoustic mirror cavity is formed between the substrate and the monocrystalline piezoelectric film layer, and the acoustic mirror cavity is a blind hole cavity.

21. A filter, comprising the bulk acoustic wave resonator according to any one of claims 1 to 11, the bulk acoustic wave resonator unit according to claim 12 or 13, or a monocrystalline film bulk acoustic wave resonator manufactured by the method according to any one of claims 14 to 20.

22. An electronic apparatus, comprising the filter according to claim 21, the bulk acoustic wave resonator according to any one of claims 1 to 11, the bulk acoustic wave resonator unit according to claim 11 or 13, or a monocrystalline film bulk acoustic wave resonator manufactured by the method according to any one of claims 14 to 20.
